(19) **Europäisches Patentamt**

**European Patent Office**

**Office européen des brevets**

(11) **EP 1 326 334 A2**

(12) **EUROPÄISCHE PATENTANMELDUNG**

(43) Veröffentlichungstag:
**09.07.2003 Patentblatt 2003/28**

(51) Int Cl.$^7$: **H03H 11/12**

(21) Anmeldenummer: **02028439.4**

(22) Anmeldetag: **18.12.2002**

(84) Benannte Vertragsstaaten:
**AT BE BG CH CY CZ DE DK EE ES FI FR GB GR
IE IT LI LU MC NL PT SE SI SK TR**
Benannte Erstreckungsstaaten:
**AL LT LV MK RO**

(30) Priorität: **04.01.2002 DE 10200123**

(71) Anmelder: **Siemens Gebäudesicherheit GmbH &
Co. OHG
80807 München (DE)**

(72) Erfinder: **Goepel, Ernst
82110 Germering (DE)**

(74) Vertreter: **Berg, Peter, Dipl.-Ing.
European Patent Attorney,
Siemens AG,
Postfach 22 16 34
80506 München (DE)**

(54) **Aktive RC-Filter-Schaltungsanordnung**

(57) Zur Realisierung von aktiven RC-Filter-Schaltungen mit maximal steilem Übergang des Amplitudengangs vom Durchlaß- in den Sperrbereich, welche der inversen Tschebyscheff- oder der Cauer-Approximation genügen, sind verschiedene Schaltungen bekannt, beispielsweise Filter nach Berka-Herpy, Ackerberg-Mossberg.

Erfindungsgemäß wird eine neue aktive RC-Filter-Schaltungsanordnung, welche Übertagungsnullstellen realisiert, angegeben, bei der die positiven Eingänge zweier Operationsverstärker (X1, X2) miteinander verbunden sind. Bei geeigneter Dimensionierung lassen sich mit der erfindungsgemäßen Schaltungsanordnung Tiefpaß-Lochfilter, Hochpaß-Lochfilter und symmetrische Lochfilter in einfacher Weise aufbauen.

FIG 2

EP 1 326 334 A2

**Beschreibung**

Die Erfindung betrifft eine aktive RC-Filter-Schaltungsanordnung.

Bei der Synthese von aktiven RC-Filterschaltungen mit maximal steilem Übergang des Amplitudengangs vom Durchlaß- in den Sperrbereich kommt die Cauer- (oder sogenannte elliptische) und die inverse Tschebyscheff-Approximation zur Anwendung. Für beide Näherungsverfahren werden zur Realisierung von Kaskadenfiltern höheren Grades biquadratische Übertragungsfunktionen T(p) der komplexen Frequenzvariablen p=σ+jω als Verhältnis der Ausgangsspannung $U_2$ zur Eingangsspannung $U_1$ der Filterschaltung in der Form

$$T(p)= \frac{U_2(p)}{U_1(p)} = \frac{N(p)}{D(p)} = \frac{a_0+a_2 p^2}{b_0+b_1 p+b_2 p^2} = T_0 \cdot \frac{1+p^2/\omega_z^2}{1+p/(Q_p\omega_p)+p^2/\omega_p^2} \qquad (1)$$

benötigt. Dabei werden die positiven Koeffizienten $a_i$ der Zählerfunktion N(p) und die positiven Koeffizienten $b_i$ der Nennerfunktion D(p) bzw. die von den Koeffizienten abgeleiteten, messbaren Filterkenngrößen, wie die Nullstellenfrequenz $\omega_z$, die Polfrequenz $\omega_p$, die Polgüte $Q_p$ und die Verstärkungskonstante $T_0$ durch die Bauelemente der jeweiligen Filterschaltungsanordnung realisiert. Obwohl gemäß der Beziehung ω=2πf mit f[Hz] die üblicherweise gemessene Frequenz und mit ω[radian/s] die Kreisfrequenz benannt sind, findet hier zur Vereinfachung der Ausdruck Frequenz für beide Größen Anwendung, wobei die eindeutige Zuordnung durch die Symbole gegeben ist.

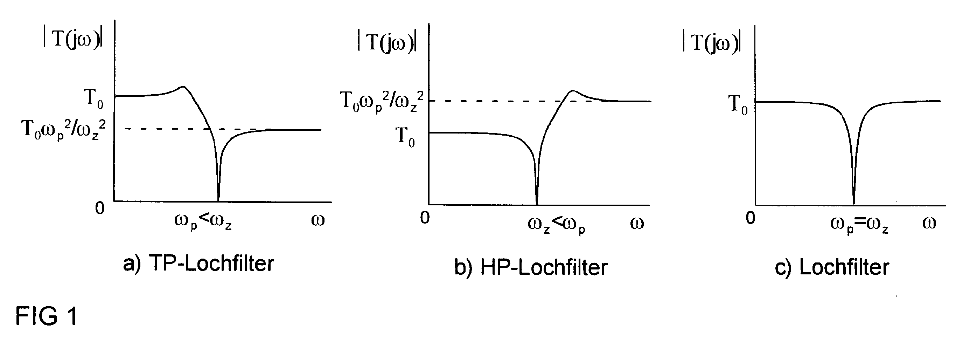

Filterschaltungen nach Gleichung (1) sind dadurch gekennzeichnet, daß für p→jω bei ω=$\omega_z$ der Amplitudengang betragsmäßig gleich Null wird, d.h. es entsteht bei der Nullstellenfrequenz $\omega_z$ ein Übertragungsloch. Die Amplitudenverläufe gemäß der Figur 1 bezeichnen für Figur 1a) ein Tiefpaßlochfilter, für Figur 1b) ein Hochpaßlochfilter und in Figur 1c) für $\omega_z$=$\omega_p$ ein symmetrisches Lochfilter, für das sich auch die Bezeichnungen Kerb- bzw. Notchfilter durchgesetzt haben.

In der analogen Schaltungstechnik, die mit zeitkontinuierlichen Signalen arbeitet, sind mehrere Schaltungen bekannt, die das oben genannte Filterapproximationsproblem lösen. Diese benutzen mehr oder weniger viele passive und aktive Bauelemente zur Realisierung. So sind aus Herpy, M., Berka, J.-C.: Aktive RC-Filter, Franzis-Verlag, München 1984, Seite 241, ein Filter nach Berka-Herpy, aus Schaumann, R., Van-Valkenburg, M.E.: Design of Analog Filters, Oxford University Press, New York, Oxford 2001, Seiten 192-198, Seiten 205 bis 207 und Seiten 306 bis 310 sog. Ackerberg-Mossberg-Schaltungen, und inverse Tschebyscheff- und Cauer-Filter bekannt. Es ist die Aufgabe der Erfindung, eine neue aktive RC-Filter-Schaltungsanordnung anzugeben.

Die Aufgabe wird erfindungsgemäß gelöst durch eine aktive RC-Filter-Schaltungsanordnung mit den Merkmalen des Patentanspruchs 1.

Die erfindungsgemäße Schaltung ist geeignet, als Lochfilterschaltung eingesetzt zu werden.

In der vorteilhaften Ausgestaltung nach Patentanspruch 3 werden zur Realisierung der Schaltung drei gleichartige Operationsverstärker eingesetzt, was die Herstellung derartiger Schaltungsanordnungen erleichtert.

Gemäß Anspruch 4 werden die Widerstände $R_4$ bis $R_9$ gleich groß gewählt, was auf eine sehr einfache Lösung des universellen Lochfilters zweiten Grades führt. Durch die Gleichheit der Widerstände mit ihrem frei wählbaren Absolutwert lassen sich solche Widerstände - zusammen mit den Operationsverstärkern - in integrierten Analogschaltungen als aktive Bauelemente präzise realisieren. Ein weiterer Vorteil dieser Schaltung ist dadurch gegeben, daß allein durch die Variation des dritten Widerstandes $R_3$ die Nullstellenfrequenz $\omega_z$ in weiten Grenzen einstellbar ist, so daß die Schaltung in gleicher Weise zum Aufbau von Tiefpaß- und Hochpaß-Lochfiltern und von symmetrischen Lochfiltern geeignet ist.

In der weiteren bevorzugten Ausgestaltung nach Patentanspruch 5 lassen sich zwei Widerstände einsparen.

Gemäß der Patentansprüche 7 und 8 lassen sich die erfindungsgemäßen Schaltungsanordnungen auch hintereinander schalten (kaskadieren), wodurch sich gewünschte Übertragungsfunktionen realisieren lassen.

Anhand der Figuren der Zeichnung wird die Erfindung näher erläutert. Dabei zeigen

Figur 1 drei grafische Darstellungen der Übertragungsfunktion in Abhängigkeit von der Frequenz für ein Tiefpaß-Lochfilter, für ein Hochpaß-Lochfilter und für ein symmetrisches Lochfilter,
Figur 2 ein Schaltbild einer erfindungsgemäßen Schaltungsanordnung,
Figur 3 einen errechneten Amplitudengang der erfindungsgemäßen Schaltungsanordnung,
Figur 4 ein Schaltbild einer weiteren erfindungsgemäßen Schaltungsanordnung,
Figur 5 ein Schaltbild eines Tiefpaßfilters vierten Grades und
Figur 6a den rechnersimulierten Amplitudengang des Tiefpaßfilters aus Figur 5 und
Figur 6b den gemessenen Amplitudengang des Tiefpaßfilters aus Figur 5.

In Figur 1 sind in drei grafischen Darstellungen die Übertragungsfunktionen |T(jω)| in Abhängigkeit von der

Frequenz $\omega$ dargestellt. Diese Übertragungsfunktionen ergeben sich in Auswertung der Gleichung (1) mit den darin befindlichen Größen. In Figur 1a) mit einer Polfrequenz $\omega_p$, die kleiner ist als die Nullstellenfrequenz $\omega_z$, ergibt sich ein Tiefpaß-Lochfilter. In Figur 1b) ist die Nullstellenfrequenz $\omega_z$ kleiner als die Polfrequenz $\omega_p$ gewählt, wodurch sich ein Hochpaß-Lochfilter ergibt. In Figur c) ist die Nullstellenfrequenz $\omega_z$ gleich der Polfrequenz $\omega_p$ gewählt, wodurch sich ein symmetrisches Lochfilter ergibt.

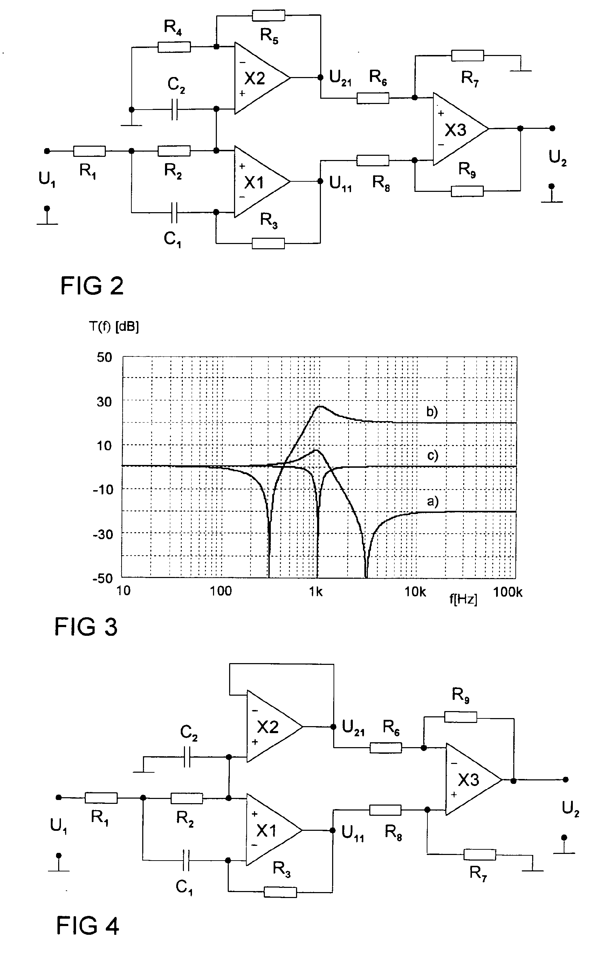

In Figur 2 ist eine erfindungsgemäße Schaltungsanordnung dargestellt. Dabei liegt die auf Masse bezogene Eingangsspannung $U_1$ über einem ersten Widerstand $R_1$ und einem zweiten Widerstand $R_2$ am positiven Eingang eines ersten Operationsverstärkers X1. Die Eingangsspannung $U_1$ liegt ferner über dem ersten Widerstand $R_1$ und einem ersten Kondensator $C_1$ am negativen Eingang des ersten Operationverstärkers X1. Der Ausgang des ersten Operationsverstärkers X1 liegt über dem dritten Widerstand $R_3$ ebenfalls am negativen Eingang des ersten Operationsverstärkers X1 an. Der negative Eingang eines zweiten Operationsverstärkers X2 liegt über einem vierten Widerstand $R_4$ an Masse, der positive Eingang des zweiten Operationsverstärkers X2 liegt über einem zweiten Kondensator $C_2$ ebenfalls an Masse. Der Ausgang des zweiten Operationsverstärkers X2 liegt über einem fünften Widerstand $R_5$ am negativen Eingang des zweiten Operationsverstärkers X2. Die beiden positiven Eingänge des ersten Operationsverstärkers X1 und des zweiten Operationsverstärkers X2 sind miteinander verbunden. Der Ausgang des zweiten Operationsverstärkers X2 liegt über einem sechsten Widerstand $R_6$ am positiven Eingang eines dritten Operationsverstärkers X3, der positive Eingang des dritten Operationsverstärkers X3 liegt über einem siebten Widerstand $R_7$ an Masse. Der Ausgang des ersten Operationsverstärkers X1 ist über einen achten Widerstand $R_8$ mit dem negativen Eingang des dritten Operationsverstärkers X3 verbunden. Der Ausgang des dritten Operationsverstärkers X3 liegt über einem neunten Widerstand $R_9$ am negativen Eingang des dritten Operationsverstärkers X3. Die auf Masse bezogene Ausgangsspannung $U_2$ der Schaltungsanordnung wird am Ausgang des dritten Operationsverstärkers X3 abgegriffen. Auf die Darstellung der Anschlüsse der Betriebsspannungsversorgung der Operationsverstärker X1...X3 wurde verzichtet.

Zur Ermittlung der Übertragungsfunktion der erfindungsgemäßen Schaltung werden die Operationsverstärker X1...X3 im unteren bis mittleren Frequenzbereich (bis ca. 50 kHz) in den Stromkreisberechnungen als ideale, mit unendlicher Leerlaufverstärkung arbeitende, spannungsgesteuerte Spannungsquellen berücksichtigt. Mit den Widerständen $R_6...R_9$ und dem dritten Operationsverstärker X3 wird die Ausgangsspannung

$$U_2 = \frac{R_9(R_6+R_7)}{R_6(R_8+R_9)}U_{21} - \frac{R_7}{R_6}U_{11} \qquad (2)$$

somit aus den an den Ausgängen des zweiten Operationsverstärkers X2 und des ersten Operationsverstärkers X1 erscheinenden Spannungen $U_{21}$, $U_{11}$ gebildet, welche sich aus den Teilübertragungsfunktionen $T_{21}$ und $T_{11}$ der erfindungsgemäßen Schaltung ergeben. Diese Teilübertragungsfunktion $T_{21}$ und $T_{11}$ sind definiert als

$$T_{21} = \frac{U_{21}}{U_1} = \frac{N_{21}}{D_{21}} \qquad (3a)$$

$$T_{11} = \frac{U_{11}}{U_1} = \frac{N_{11}}{D_{11}} \qquad (3b)$$

mit den Eigenschaften, daß einerseits ihre Nenner $D_{21}$, $D_{11}$, mit denen das für die Filterschaltung notwendige konjugiert komplexe Polpaar realisiert wird, gleich sind:

$$D_{21}(p)=D_{11}(p)=D(p)=1+p(R_1+R_2)C_2 + p^2 R_1 R_2 C_1 C_2. \qquad (4)$$

Andererseits wird durch die Beschaltung der Zähler $N_{21}$ als frequenzunabhängiger Verstärkungsfaktor:

$$N_{21}(p)=(R_4+R_5)/R_4 \qquad (5a)$$

und der Zähler $N_{11}$ als konjugiert reelles Nullstellenpaar ausgebildet:

$$N_{11}(p)=1-p^2 R_2 R_3 C_2 C_3. \tag{5b}$$

Mit den Gleichungen (3), (4) und (5) erhält man nach der Differenzbildung gemäß Gleichung (2) am Ausgang des dritten Operationsverstärkers X3 die Übertragungsfunktion

$$T(p) = \frac{N(p)}{D(p)} = \frac{(R_4+R_5)\frac{R_9(R_6+R_7)}{R_4 R_6(R_8+R_9)}-\frac{R_7}{R_6}(1-p^2 R_2 R_3 C_1 C_2)}{1+p(R_1+R_2)C_2 + p^2 R_1 R_2 C_1 C_2} \tag{6}$$

mit dem gewünschten Ergebnis: im Zähler N(p) entsteht ein konjugiert imaginäres Nullstellenpaar, welches durch die arithmetische Operation aus dem konjugiert reellen Nullstellenpaar geschaffen wurde. Als ein weiteres Merkmal der Erfindung ergibt sich nämlich bei Gleichheit der in ihrem Absolutwert frei wählbaren Widerstände $R_4=R_5=R_6=R_7=R_8=R_9$ als Ziel die sehr einfache Lösung des universellen Lochfilters zweiten Grades:

$$T(p) = \frac{U2(p)}{U1(p)} = \frac{1+p^2 R_2 R_3 C_1 C_2}{1+p(R_1+R_2)C_2 + p^2 R_1 R_2 C_1 C_2}. \tag{7}$$

Hierbei bestimmten lediglich fünf Bauelemente $R_1$, $R_2$, $R_3$, $C_1$ und $C_2$ den Frequenzgang und es ergeben sich - verglichen mit anderen Filterschaltungen - folgende einfachen Filterkenngrößen gemäß Gleichung (1) $T_0=1$, $\omega_z=(R_2 R_3 C_1 C_2)^{-1/2}$, $\omega_p=(R_1 R_2 C_1 C_2)^{-1/2}$, d.h. falls $R_1=R_2$ gewählt wird $\omega_z=\omega_p(R_1/R_3)^{1/2}$, und $Q_p=0,5(C_1/C_2)^{1/2}$.

Die Gleichheit der Widerstände $R_4$ bis $R_9$ mit ihrem frei wählbaren Absolutwert ist herstellungstechnisch von Bedeutung, insofern sich solche Widerstände, zusammen mit den Operationsverstärkern X1 bis X3 in integrierten Analogschaltungen als aktive Bauelemente präzise realisieren lassen. Ein weiterer anwendungstechnischer Vorteil der Schaltung ist dadurch gegeben, daß der dritte Widerstand $R_3$ nur im quadratischen Term des Zählers von Gleichung (7) erscheint und daß allein durch seine Variation die Nullstellenfrequenz $\omega_z$ in weiten Grenzen einstellbar ist, so daß - wie in Figur 3 gezeigt - die Schaltung in gleicher Weise zum Aufbau von Tiefpaß- und Hochpaß-Lochfiltern und von symmetrischen Lochfiltern geeignet ist. Für die Darstellung in Figur 3 wurden die Bauelemente $R_1=R_2=10k\Omega$; $C_1=80nF$; $C_2=3,2nF$, $R_4...R_9=10k\Omega$ gewählt. Der Verstärkungsfaktor ist hierbei $T_0=1$, entsprechend 0dB. Die Polfrequenz $f_p$ bestimmt sich damit zu 1kHz und die Polgüte $Q_p$ zu 2,5. Wird der dritte Widerstand $R_3=100k\Omega$ gewählt, ergibt sich die Nullstellenfrequenz zu $f_z = 3,16kHz$ und daraus resultiert die Kurve a) in der Figur 3 (ein Tiefpaß-Lochfilter). Wird der dritte Widerstand $R_3=1k\Omega$ gewählt, ergibt sich eine Nullstellenfrequenz $f_z=316Hz$ und die Kurve b) in Figur 3 (ein Hochpaß-Lochfilter). Die Kurve c) und damit ein symmetrisches Lochfilter ergibt sich für eine Wahl des dritten Widerstandes $R_3$ von 10k$\Omega$, woraus eine Nullstellenfrequenz $f_z=1kHz$ resultiert.

In Figur 4 ist ein Schaltbild für eine invertierte Lösung dargestellt, die ebenfalls (bis auf ein negatives Vorzeichen) auf die vereinfachte Übertragungsfunktion (Gl.(7)) führt. Dabei erfolgt am zweiten Operationsverstärker X2 die Rückkopplung widerstandsfrei ($R_5 = 0\Omega$) (durch eine Drahtbrücke). Die Größe des vierten Widerstands $R_4$ ist dann für die Bestimmung der Übertragungsfunktion nicht relevant (siehe Gl. (5a)). Dadurch wird ein Spannungsfolger realisiert. In diesem Ausführungsbeispiel sind dann allerdings die Eingänge des dritten Operationsverstärkers X3 zu vertauschen, so dass die Ausgangsspannung $U_{21}$ des zweiten Operationsverstärkers X2 am negativen Eingang und die Ausgangsspannung $U_{11}$ des ersten Operationsverstärkers X1 am positiven Eingang anliegt. Außerdem ist der achte Widerstand $R_8$, der zwischen Ausgang des ersten Operationsverstärkers X1 und positivem Eingang des dritten Operationsverstärkers X3 liegt und der neunte Widerstand $R_9$ - der Rückkopplungswiderstand zwischen Ausgang des dritten Operationsverstärkers X3 und negativem Eingang des dritten Operationsverstärkers X3 - doppelt so groß wie der sechste Widerstand $R_6$ - zwischen Ausgang des zweiten Operationsverstärkers X2 und negativem Eingang des dritten Operationsverstärkers X3 - und der siebte Widerstand $R_7$ - zwischen positivem Eingang des dritten Operationsverstärkers X3 und Masse - zu wählen.

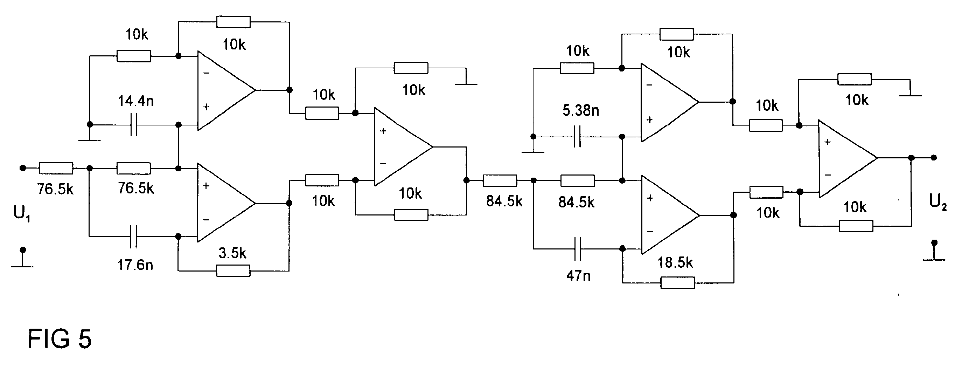

Als weiteres Ausführungsbeispiel ist in Figur 5 die Schaltung eines Tiefpaßfilters vierten Grades angegeben. Dabei sind zwei Schaltungsanordnungen der Ausführungsform nach Figur 2 in Serie geschaltet und die Ausgangsspannung $U_2$ wird am Ausgang des letzten Operationsverstärkers abgegriffen. Für den ersten Teil (in der Schaltungsanordnung links dargestellt) wurden der erste Widerstand $R_1$ und der zweite Widerstand $R_2=76,5k\Omega$ gewählt, der erste Kondensator $C_1=17,6nF$ und der zweite Kondensator $C_2=14,4nF$. Der dritte Widerstand $R_3$ wurde zu 3,5k$\Omega$ gewählt. Im zweiten Teil der Schaltungsanordnung (in der Figur rechts dargestellt) wurden der erste Widerstand und der zweite Widerstand gleich 84,5k$\Omega$ gewählt, der erste Kondensator gleich 47 nF und der zweite Kondensator zu 5,38nF. Der dritte Widerstand wurde zu 18,5k$\Omega$ gewählt. Alle weiteren Widerstände wurden als 10k$\Omega$-Widerstände realisiert.

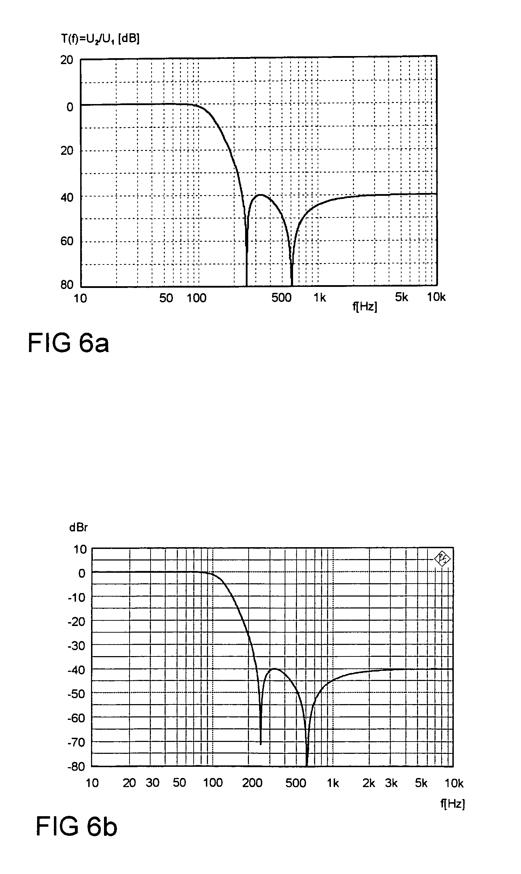

In Figur 6a ist der rechnersimulierte Amplitudengang für dieses Tiefpaßfilter vierten Grades mit 40 dB Sperrbereichsdämpfung in inverser Tschebyscheff-Approximation angegeben. In Figur 6b ist der gemessene Amplitudengang bei Verwendung von 1% genauen Bauelementen angezeigt. Der gemessene Amplitudengang zeigt eine gute Übereinstimmung mit dem theoretischen Verlauf.

Die Filterkenngrößen ergeben sich gemäß Herpy-Berka (s.o.) Seite 262 zu einer Grenzfrequenz $f_g$=100Hz, einer Durchlaßdämpfung bei der Grenzfrequenz von 1dB, einer Sperrdämpfung von 40dB bei Sperrfrequenzen $f_s$>234Hz, einer ersten Polfrequenz $f_{p1}$=118Hz, einer zweiten Polfrequenz $f_{p2}$=131Hz, einer ersten Polgüte $Q_{p1}$=1,48 und einer zweiten Polgüte $Q_{p2}$=0,554. Die Nullstellenfrequenzen liegen bei $f_{z1}$=253Hz und $f_{z2}$=611Hz. Als Verstär-kungsfaktor wurde $T_0$=1, d.h. 0dB vorgegeben.

Für den Fachmann ist klar, dass anstelle der frequenzbestimmenden Bauelemente um den ersten Operationsverstärker X1 auch die dazu dualen Bauelemente geeignet sind, die FilterStrukturen aufzubauen ($R_i$=1/$pC_i$).


**Patentansprüche**

1.  Aktive RC-Filter-Schaltungsanordnung mit einem ersten und einem zweiten Operationsverstärker (X1, X2), die jeweils einen positiven und einen negativen Eingang umfassen, bei der eine Eingangsspannung ($U_1$) über einen ersten Widerstand ($R_1$) und einen zweiten Widerstand ($R_2$) am positiven Eingang des ersten Operationsverstärkers (X1) anliegt, und die Eingangsspannung über den ersten Widerstand (R1) und einen ersten Kondensator ($C_1$) am negativen Eingang des ersten Operationsverstärkers (X1) anliegt,
    bei der der Ausgang des ersten Operationsverstärkers mit seinem negativen Eingang über einen dritten Wider-stand ($R_3$) rückgekoppelt ist,
    bei der der positive Eingang des zweiten Operationsverstärkers (X2) über einen zweiten Kondensator ($C_2$) an Masse liegt, bei der die positiven Eingänge des ersten und des zweiten Operationsverstärkers (X1, X2) miteinander verbunden sind,
    bei der der Ausgang des zweiten Operationsverstärkers (X2) mit dem negativen Eingang des zweiten Operationsverstärkers (X2) rückgekoppelt ist
    und bei der die Ausgänge des ersten und des zweiten Operationsverstärkers (X1,X2) mit einer Differenzschaltung verbunden sind, an deren Ausgang die Ausgangsspannung ($U_2$) abgegriffen wird.

2.  Aktive RC-Filter-Schaltungsanordnung nach Anspruch 1,
    **dadurch gekennzeichnet, dass**
    der negative Eingang des zweiten Operationsverstärkers (X2) über einen vierten Widerstand ($R_4$) an Masse liegt und der Ausgang des zweiten Operationsverstärkers (X2) über einen fünften Widerstand ($R_5$) mit dem negativen Eingang des zweiten Operationsverstärkers (X2) rückgekoppelt ist.

3.  Aktive RC-Filter-Schaltungsanordnung nach Anspruch 2,
    **dadurch gekennzeichnet, dass**
    die Differenzschaltungsanordnung derartig ausgebildet ist, dass
    der Ausgang des zweiten Operationsverstärkers über einen sechsten Widerstand ($R_6$) am positiven Eingang eines dritten Operationsverstärkers (X3) anliegt und der positive Eingang des des dritten Operationsverstärkers (X3) zusätzlich über einen siebten Widerstand ($R_7$) an Masse anliegt,
    der Ausgang des ersten Operationsverstärkers (X1) über einen achten Widerstand ($R_8$) am negativen Eingang des dritten Operationsverstärkers (X3) anliegt,
    der Ausgang des dritten Operationsverstärkers (X3) über einen neunten Widerstand ($R_9$) an den negativen Ein-gang des dritten Operationsverstärkers (X3) rückgekoppelt ist und
    die Ausgangsspannung ($U_2$) am Ausgang des dritten Operationsverstärkers (X3) abgegriffen wird.

4.  Aktive RC-Filter-Schaltungsanordnung nach Anspruch 3,
    **dadurch gekennzeichnet, dass**
    der vierte Widerstand ($R_4$), der fünfte Widerstand ($R_5$), der sechste Widerstand ($R_6$), der siebte Widerstand ($R_7$), der achte Widerstand ($R_8$) und der neunte Widerstand ($R_9$) gleich groß gewählt sind.

5.  Aktive RC-Filter-Schaltungsanordnung nach Anspruch 1,
    **dadurch gekennzeichnet, dass**
    die Differenzschaltungsanordnung derartig ausgebildet ist, dass
    der Ausgang des zweiten Operationsverstärkers über einen sechsten Widerstand ($R_6$) am negativen Eingang eines dritten Operationsverstärkers (X3) anliegt,
    der positive Eingang des dritten Operationsverstärkers (X3) über einen siebten Widerstand ($R_7$) an Masse anliegt,

der Ausgang des ersten Operationsverstärkers (X1) über einen achten Widerstand ($R_8$) am positiven Eingang des dritten Operationsverstärkers (X3) anliegt und
der Ausgang des dritten Operationsverstärkers (X3) über einen neunten Widerstand ($R_9$) an den negativen Eingang des dritten Operationsverstärkers (X3) rückgekoppelt ist und
die Ausgangsspannung ($U_2$) am Ausgang des dritten Operationsverstärkers (X3) abgegriffen wird.

6.   Aktive RC-Filter-Schaltungsanordnung nach Anspruch 5,
     **dadurch gekennzeichnet, dass**
     der sechste Widerstand ($R_6$) und der siebte Widerstand ($R_7$) gleich groß und der achte Widerstand ($R_8$) und der neunte Widerstand ($R_9$) jeweils doppelt so groß wie der sechste Widerstand ($R_6$) gewählt sind.

7.   Aktive RC-Filter-Schaltungsanordnung,
     **dadurch gekennzeichnet, dass**
     zwei oder mehr Schaltungsanordnungen nach einem der Ansprüche 1 bis 6 in Reihe geschaltet sind.

8.   Aktive RC-Filter-Schaltungsanordnung nach Anspruch 5,
     **dadurch gekennzeichnet, dass**
     die in Reihe geschalteten Schaltungsanordnungen jeweils unterschiedlich dimensioniert sind.

EP 1 326 334 A2

a) TP-Lochfilter

b) HP-Lochfilter

c) Lochfilter

FIG 1

FIG 2

FIG 3

FIG 4

FIG 5

FIG 6a

FIG 6b